Europäisches Patentamt

European Patent Office

Office européen des brevets

(19)

(11) Veröffentlichungsnummer: **0 180 055**
**A2**

(12) **EUROPÄISCHE PATENTANMELDUNG**

(21) Anmeldenummer: **85112549.2**

(22) Anmeldetag: **03.10.85**

(51) Int. Cl.⁴: **H 01 R 13/41, H 01 R 9/09**

(30) Priorität: **31.10.84 DE 3439839**

(43) Veröffentlichungstag der Anmeldung: **07.05.86**
**Patentblatt 86/19**

(84) Benannte Vertragsstaaten: **CH DE FR GB IT LI SE**

(71) Anmelder: **Siemens Aktiengesellschaft, Berlin und München Wittelsbacherplatz 2, D-8000 München 2 (DE)**

(72) Erfinder: **Seibold, Jürgen, Ing. grad., Fichtenstrasse 1, D-8021 Baierbrunn (DE)**
Erfinder: **Glomb, Kurt, Ing. grad., Nelkenstrasse 11, D-8034 Germering (DE)**
Erfinder: **Pelzl, Leo, Ing. grad., Alpenblickstrasse 5, D-8150 Holzkirchen (DE)**
Erfinder: **Neuber, Georg, Ing. grad., Hans-Böckler-Strasse 20, D-8000 München 50 (DE)**

(54) **Kontaktfeder für elektrische Steckverbinderleisten.**

(57) Bei einer Kontaktfeder für elektrische Steckverbinderleisten, die an ihrem einen Ende einen Kontakt und an ihrem anderen Ende eine Anschlußfahne (1) zum Einpressen in eine Leiterplattenbohrung aufweist, ist die Anschlußfahne (1) im Einpreßbereich (2) V-förmig gestaltet, um bei geringer Einpreßkraft eine sichere Kontaktierung zu gewährleisten.

Siemens Aktiengesellschaft          Unser Zeichen
Berlin und München          1          VPA 84 P 1901 E

Kontaktfeder für elektrische Steckverbinderleisten

Die Erfindung betrifft eine Kontaktfeder für elektrische Steckverbinderleisten, die an ihrem einen Ende einen Kontakt und an ihrem anderen Ende eine Anschlußfahne zum Einpressen in die Bohrung einer Leiterplatte aufweist.

Die Anschlußfahnen derartiger Kontaktfedern, die in metallisierte Bohrungen einer Leiterplatte eingepreßt werden, müssen einen sicheren elektrischen Kontakt sowie eine sichere mechanische Verbindung gewährleisten. Daher muß die Anschlußfahne mit einer großen Kraft auf die Bohrungswände einwirken. Dies läuft der Forderung nach einer möglichst geringen Einpreßkraft zuwider, um die Kontaktfeder, bzw. die Anschlußfahne nicht übermäßig groß zu dimensionieren.

Aufgabe der vorliegenden Erfindung ist es, eine Kontaktfeder der eingangs genannten Art anzugeben, deren Anschlußfahne bei möglichst geringer Einpreßkraft einen guten elektrischen Kontakt und eine sichere mechanische Verbindung mit der Leiterplatte gewährleistet.

Diese Aufgabe wird bei einer Kontaktfeder der obengenannten Art erfindungsgemäß dadurch gelöst, daß die Anschlußfahne im Einpreßbereich V-förmig gebogen ist, und daß die beiden, den V-förmigen Bereich bildenden Seitenschenkel zum freien Ende der Anschlußfahne hin schräg aufeinander zulaufen.

Som 1 Sur / 30.10.1984

Beim Einpressen der Kontaktfahne in die metallisierte Leiterplattenbohrung entstehen zwischen dem V-förmigen Profil und der Lochlaibung drei Berührungszonen, nämlich an den äußeren Kanten der Seitenschenkel und am Biegewulst. Der Öffnungswinkel des V-förmigen Bereiches drückt sich beim Einpressen im Bereich der Durchmessertoleranzen zusammen. Durch den wannenförmigen Bereich der Einpreßzone der Kontaktfahne ergibt sich bei einer hohen Elastizität gleichzeitig eine große Steifheit bzw. Stabilität der Anschlußfahne. Bei der erfindungsgemäßen Kontaktfeder erfordert das Einpressen der Anschlußfahne keine hohen Einpreßkräfte, gleichzeitig ist aber eine hohe Kontaktsicherheit gewährleistet.

Eine Weiterbildung der erfindungsgemäßen Kontaktfeder ist dadurch gekennzeichnet, daß der Einpreßbereich der Anschlußfahne zum unfreien Ende hin von zwei gegenüberliegenden kragenförmigen Verbreiterungen begrenzt ist, und daß der V-förmige Bereich zwischen den Verbreiterungen ausläuft. Dadurch ergibt sich eine gute Übertragung der Einpreßkräfte auf die beiden Seitenschenkel des V-förmigen Einpreßbereiches.

Eine weitere Ausbildung der erfindungsgemäßen Kontaktfeder ist dadurch gekennzeichnet, daß die zum freien Ende der Anschlußfahne hin schräg aufeinander zulaufenden Seitenschenkel eine im wesentlichen abgerundete Spitze bilden, die beim Einführen der Anschlußfahne in die Leiterplatte in der Bohrungsmitte verläuft. Dadurch ist ein exaktes Einführen der Kontaktfeder in die Leiterplattenbohrungen gewährleistet.

Andere vorteilhafte Weiterbildungen der erfindungsgemäßen Kontaktfeder ergeben sich aus den restlichen Unteransprüchen sowie aus der nachfolgenden Beschreibung eines Ausführungsbeispieles der Erfindung.

Nachfolgend wird anhand eines in der Zeichnung dargestellten Ausführungsbeispieles die Erfindung näher erläutert.


Es zeigen

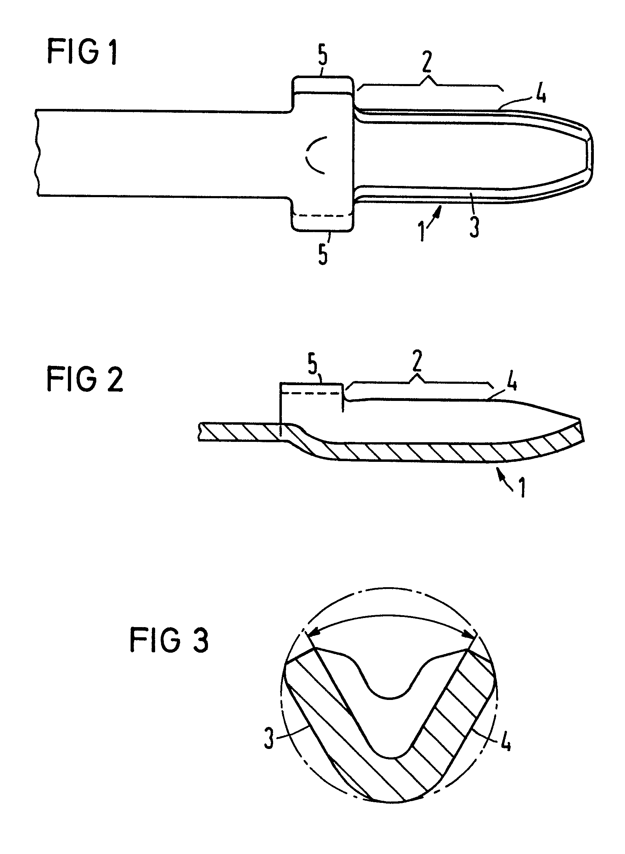

FIG 1   eine Draufsicht der Anschlußfahne der erfindungsgemäßen Kontaktfeder,
FIG 2   einen Längsschnitt durch die Anschlußfahne und
FIG 3   einen Querschnitt durch die Einpreßzone der Anschlußfahne der elektrischen Kontaktfeder.


Von der erfindungsgemäßen Kontaktfeder ist im Ausführungsbeispiel nur die Anschlußfahne 1 dargestellt. Die Kontaktfeder, einschließlich der Anschlußfahne 1, ist einstückig
aus flachem Bandmaterial hergestellt. Der V-förmige Einpreßbereich 2 der Anschlußfahne 1 wird von den beiden Seitenschenkeln 3 und 4 gebildet. Zum freien Ende der Anschlußfahne 1 hin, ist der Einpreßbereich durch die
schräg aufeinander zulaufenden Seitenschenkel 3 und 4 begrenzt. Auf der anderen Seite wird der V-förmige Einpreßbereich durch die kragenförmigen Verbreiterungen 5 begrenzt. Diese beiden kragenförmigen Verbreiterungen 5 dienen dazu, ein Einpreßwerkzeug anzusetzen. Im dargestellten Ausführungsbeispiel sind die beiden Verbreiterungen 5
schräg zur Ebene der Kontaktfeder und in entgegengesetzter Richtung abgebogen.


Beim Einpressen der Anschlußfahne in eine hier nicht dargestellte metallisierte Leiterplattenbohrung entstehen
zwischen dem V-förmigen Profil der Einpreßzone und der
Lochlaibung 3 Berührungszonen, nämlich an den äußeren
Kanten der beiden Seitenschenkel 3 und 4 sowie am Biegewulst. Aufgrund des Öffnungswinkels des V-förmigen Einpreßbereiches drückt sich dieser beim Einpressen im Bereich der Toleranzen der Durchmesser der Leiterplattenbohrungen zusammen, wobei sich eine Restfederung ergibt,
die eine sichere Kontaktgabe gewährleistet. Durch die
"löffelförmige" Begrenzungen des Einpreßbereiches an beiden Seiten weist die Anschlußfahne 1 gleichzeitig die gewünschte Steifheit und Stabilität auf. Dadurch, daß der
eine Endbereich des V-förmigen Einpreßbereiches 2 zwischen den Verbreiterungen 5 zu liegen kommt, können die
Einpreßkräfte sicher auf die beiden Seitenschenkel 3 und
4 übertragen werden.

Als besonders vorteilhaft hat sich herausgestellt, die
Seitenschenkel 3 und 4 in einem Winkel von 60° bilden zu
lassen. Bei der erfindungsgemäßen Kontaktfeder ergibt
sich aufgrund ihrer besonderen Form, daß die Einpreßkraft
gleich der Ausziehkraft ist. Dies ist besonders wichtig,
wenn aus irgendeinem Grund defekte Kontaktfedern ausgewechselt werden müssen.

Bei der erfindungsgemäßen Kontaktfeder sind die äußeren
Kanten der beiden Seitenschenkel 3 und 4 der Anschlußfahne 1 abgerundet. Gleichzeitig bilden die zum freien Ende
der Anschlußfahne hin schräg aufeinander zulaufenden Seitenschenkel 3 und 4 eine im wesentlichen abgerundete
Spitze, die beim Einführen der Anschlußfahne 1 in die
Leiterplattenbohrung mittig auf die Bohrung auftreffen.
Dadurch ist sichergestellt, daß die Anschlußfahnen 1
zielgenau und sanft in die Leiterplattenbohrung einleiten können, wodurch ein unnötiges Spanabheben von der
metallisierten Laibung der Leiterplattenbohrung vermieden
wird.

5 Patentansprüche
3 Figuren

Patentansprüche

1. Kontaktfeder für elektrische Steckverbinderleisten, die an ihrem einen Ende einen Kontakt und an ihrem anderen Ende eine Anschlußfahne zum Einpressen in die Bohrung einer Leiterplatte aufweist, d a d u r c h   g e - k e n n z e i c h n e t , daß die Anschlußfahne (1) im Einpreßbereich (2) V-förmig gebogen ist, und daß die beiden, den V-förmigen Bereich bildenden Seitenschenkel (3, 4) zum freien Ende der Anschlußfahne (1) schräg aufeinander zulaufen.

2. Kontaktfeder nach Anspruch 1, d a d u r c h   g e - k e n n z e i c h n e t , daß der Einpreßbereich (2) der Anschlußfahne (1) zum unfreien Ende hin von zwei gegenüberliegenden kragenförmigen Verbreiterungen (5) begrenzt ist, und daß der V-förmige Bereich zwischen diesen Verbreiterungen ausläuft.

3. Kontaktfeder nach Anspruch 1 oder 2, d a d u r c h   g e k e n n z e i c h n e t , daß die zum freien Ende der Anschlußfahne (1) hin schräg aufeinander zulaufenden Seitenschenkel (3, 4) eine im wesentlichen abgerundete Spitze bilden, die beim Einführen der Anschlußfahne (1) in die Leiterplatte in der Bohrungsmitte verläuft.

4. Kontaktfeder nach Anspruch 1 oder 2, d a d u r c h   g e k e n n z e i c h n e t , daß die beiden den V-förmigen Bereich bildenden Seitenschenkel (3, 4) einen Winkel von $60^{\circ}$ bilden.

5. Kontaktfeder nach Anspruch 1 oder 2, d a d u r c h   g e k e n n z e i c h n e t , daß die äußeren Kanten der beiden Seitenschenkel (3, 4) abgerundet sind.

FIG 1

FIG 2

FIG 3